(19) Europäisches Patentamt

European Patent Office

Office européen des brevets

(11) EP 1 416 638 A1

(12) **EUROPEAN PATENT APPLICATION**

(43) Date of publication:
06.05.2004 Bulletin 2004/19

(51) Int Cl.⁷: H03L 7/093, H04B 1/707

(21) Application number: 03256836.2

(22) Date of filing: 29.10.2003

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: **30.10.2002 SG 200206603**

(71) Applicants:
• **Agency for Science, Technology and Research**
  **Singapore 138668 (SG)**
• **STMicroelectronics Asia Pacific Pte Ltd.**
  **Singapore 569508 (SG)**

(72) Inventors:
• **Aldridge, Chris**
  **Singapore 538805 (SG)**
• **Wang, Yuhong**
  **Singapore 610365 (SG)**

(74) Representative: **Harrison Goddard Foote**
**Belgrave Hall**
**Belgrave Street**
**Leeds LS2 8DD (GB)**

(54) **Method and apparatus for a control signal generating circuit**

(57)   A control signal generating circuit (460) for an automatic frequency control (AFC) circuit (465), in accordance with the present invention receives a digital timing control signal directly from the output of a digital loop filter (138) of a tracking circuit (430), and produces a frequency control signal that is provided to a VCXO (110). The control signal generating circuit (460) comprises a multiplier (462) and an integrator (466) which are relatively simple to implement, and does not require complex processing, such as determining an inverse tangent as taught by the prior. Consequently, approximation errors associated with inverse tangent processing are avoided.

*FIG. 4*

**Description**

Field of the Invention

The present invention relates to a control signal generating circuit in a communication system and more particularly to a control signal generating circuit for an automatic frequency control (AFC) circuit in a code division multiple access (CDMA) communication system.

Background of the Invention

In a CDMA system, each user is assigned a pseudo-noise (PN) code (PN) or PN random sequence. The PN code is constructed from channelization codes and scrambling codes, and has a much higher bit rate, referred to as the chip rate, than the symbol-rate of the information being transmitted. The chip rate is typically $2^l$ i.e. 2, 4, 8, 16, 32, etc. times higher than the symbol rate.

In a CDMA base station, information for transmission modulates the PN code, and the resultant chip rate sequence is passed through a filter with a root-raised cosine frequency characteristic. The filtered output signal is then modulated on a radio frequency (RF) carrier signal, which is then transmitted.

In a Frequency Division Duplex (FDD) CDMA system, the base station uses radio frequency f1 to transmit downlink signals to a mobile station. In the mobile station, a locally generated reference signal with frequency f1' is used to receive the transmitted signal. Ideally, the frequency f1 at the base station should be equal to the frequency f1' at the mobile station. However, since the two frequencies f1 and f1' are generated using different reference sources, typically there will be a difference between the two frequencies f1 and f1'.

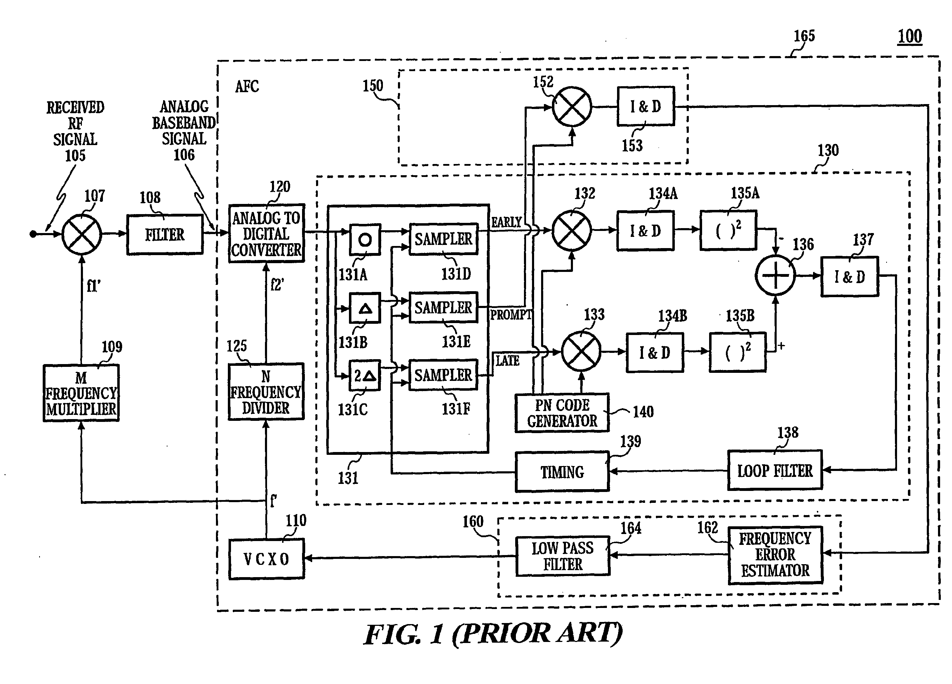

With reference to FIG. 1, in order to recover the information from a received signal, a CDMA receiver 100 of the mobile station first down converts a received RF signal 105 to a baseband signal 106 using a mixer 107, a filter 108, and the locally derived reference signal with frequency f1'.

The received RF signal 105 may expressed as follows:

$$r(t) = s(t)\exp(j2\pi f1t)$$

where s(t) is the baseband signal carrying the user specific information; and
where f1 is the RF carrier frequency.

After down conversion, the baseband signal 106 can be written as:

$$r(t)' = s(t)\exp(j2\pi\Delta ft)$$

where $\Delta f = f1 - f1'$ is the frequency error between the received signal and the locally generated reference signal.

The frequency reference f1' is provided by a frequency multiplier 109, which multiplies the frequency f' of a locally generated frequency reference signal, that is generated by a VCXO (voltage controlled crystal oscillator) 110.

After down converting, an analog-to-digital converter (ADC) 120 converts the analog baseband signal 106 to a digital signal. The ADC 120 is provided with a sampling clock signal having a derived reference frequency f2', and which is also derived from the frequency reference f' provided by the VCXO 110, where a frequency divider 125 divides the frequency of reference frequency f' to produce the frequency f2'.

A rake receiver, such as will be known to one skilled in the art, then processes the digital signal output from the ADC 120. The rake receiver has several fingers, where each finger independently demodulates different multipath signals, and then combines the multipath signals to exploit the channel diversity. In each rake finger, there are 3 branches, namely, an early branch, a late branch and a prompt branch. The early and late branches are used for generating a code tracking error signal, and the prompt branch is used for despreading data and obtaining the frequency error $\Delta f = f1 - f1'$.

In a rake finger the early and late branches are used to implement a tracking circuit 130, and the prompt branch is implemented by a despreading circuit 150. In one of the rake fingers, the despreading circuit 150 operates with a control signal generating circuit 160 to provide an AFC circuit 165, which minimises the frequency error $\Delta f = f1 - f1'$. The AFC circuit 165 is a PLL, which comprises the tracking circuit 130, the despreading circuit 150, and the control signal generating circuit 160, each of which will be described in more detail later.

The frequency f2' of the sampling signal, that is provided to the ADC 120, should be a frequency f2, where f2=f/N, with N=4 or 8, typically. However, due to a difference in the reference frequencies f and f' at the base station and the mobile station, the actual sampling frequency at the mobile station is f2'.

The relationship between the reference frequencies f and f, can be written as:

$$f' = f (1+Xppm)$$

where X is the relative difference, and 1ppm=1e-6.

Since the frequencies f1' and f2' are derived from the same reference frequency f, which is provided by the VCXO 110, and the relationship between the frequencies f and f1, and the frequencies f and f2 are: fl=Mf and f2=f/N, respectively, the relationships between f1 and f1' and between f2 and f2' can be expressed as follows:

$$f1' = f1 (1+Xppm)$$

$$f2' = f2 (1+Xppm)$$

In order to reduce the frequency difference between the frequencies f1 and f1', the mobile station employs the AFC circuit 165 to synchronize the frequency f1' of the locally generated signal to the frequency f1 of the received signal. In the control signal generating circuit 160 a frequency error estimator 162 estimates the frequency error $\Delta f=f1-f1'$ between the frequencies f1 and f1', and produces a frequency error signal. Subsequently, the frequency error signal is provided to a low pass filter 164, which produces a frequency control signal. The frequency control signal is then applied to the VCXO 110 to control the frequency f of the output signal of the VCXO 110, such that the frequency error $\Delta f=f1 -f1'$ is minimised. The control signal generating circuit 160 will be described in more detail later.

In a 3GPP (3rd Generation Partnership Project) FDD system, in order to provide coherent detection and simplify channel estimation, a common pilot channel (CPICH) is transmitted in parallel with a dedicated physical data channel (DPCH). The known data symbol on the CPICH is used for tracking and for frequency error estimation. As is known to one skilled in the art, tracking is the process of achieving and maintaining fine alignment of the phase of the received PN code and the locally generated PN code, and can be performed on the CPICH channel.

In the conventional CDMA receiver 100, the tracking circuit 130 and the control signal generating circuit 160 are different functional units, with the tracking circuit 130 using the data symbol on the CPICH channel for tracking, and the control signal generating circuit 160 using the data symbol on the CPICH channel for estimating the frequency error between the frequencies f1 and f1'. The tracking circuit 130 comprises a down sampler 131 that down samples a received CPICH signal by a factor of 4 or 8, typically. The down sampler 131 is coupled to a pair of early and late multipliers 132 and 133, respectively; the outputs of which are separately processed by integrate and dump (I&D) processors 134A and 134B, and the resultant outputs squared by squaring modules 135A and 135B. The outputs of the squaring modules 135A and 135B are then added together by an adder 136, and processed by another I&D processor 137. The code tracking error signal at the output of the I&D processor 137 is then provided to a loop filter 138, which provides a timing control signal to a timing module 139. The timing control signal comprises timing control outputs, which are digital outputs indicating one of three states i.e. 1, 0 or -1. As the timing module 139 receives the timing control outputs, the timing module 139 provides a timing signal to the down sampler 131 to maintain alignment between the PN code of the received signal and the locally generated PN code.

The down sampler 131 comprises three delay modules 131A, 131B and 131C, each imposing a predetermined time delay 0, $\Delta$ and $2\Delta$, respectively, and being equally spaced apart in time by the time $\Delta$. The output from the delay modules are each coupled to respective samplers 131D, 131E and 131F, which provide the outputs labelled early, prompt and late. The timing signal from the timing module 139 is coupled to the samplers 131D, 131E and 131F, and determines when the samplers 131D-F perform their simultaneous sampling operation.

The despreading circuit 150 is coupled to a prompt multiplier 152, which provides a prompt correlation output signal which is processed by an integrate and dump (I&D) processor 153. The I&D processor 153 provides the despread signal to the control signal generating circuit 160.

Returning now to the tracking circuit 130, the code tracking error signal P(n) is determined and provided by the pair of early and late multipliers 132 and 133, the I&D processors 134A and134B, the squaring modules 135A and 135B, the adder 136, and the I&D processor 137.

For an understanding of the operation of the tracking circuit 130, where the early correlation output signal from the I&D processor module 134A is:

$$I_e(n)+jQ_e(n), \text{ n = 1, 2...;}$$

and the late correlation output signal from the I&D processor module 134B is:

$$I_l\,(n) + jQ_l\,(n), \text{ n = 1, 2...}$$

The code tracking error signal *P(n)* from the adder 136 can then be written as:

$$P(n) = [I^2_l\,(n) + Q^2_l\,(n)] - [I^2_e(n) + Q^2_e\,(n)]$$

In 3GPP FDD specification, the CPICH signal comprises a series of frames with 15 slots in each frame, and where each slot has 10 symbols. In order to reduce the effect of noise, the code tracking error signal *P(n)* is averaged over a slot interval i.e. over a 10 symbol period to get:

$$\hat{P}(m) = \sum_{n=1}^{10} P(n) \text{ m=1, 2, ...}$$

The averaged code tracking error signal $\hat{P}(m)$ from the I&D processor 137 is then provided to the loop filter 138, which determines whether the timing of the timing module 139, should be advanced by a predetermined number of chips or delayed by a predetermined number of chips. Since each frame has 15 slots, 15 averaged values of the averaged code tracking error signal *P(m)* can be derived from each frame.

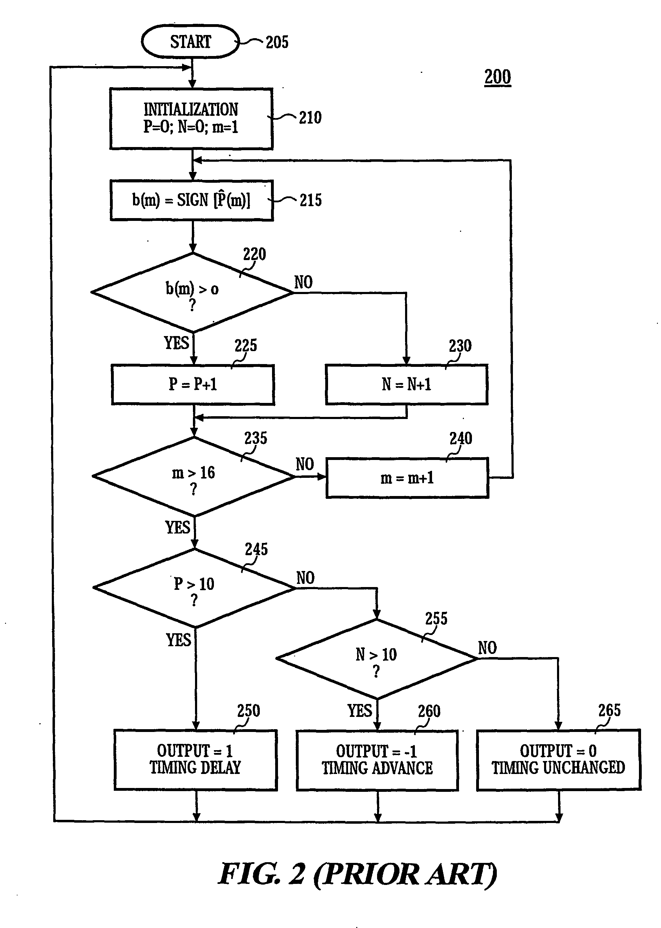

With reference to FIG. 2, the operation 200 of the loop filter 138 starts 205 with initializing 210 a positive counter P, a negative counter N, and a slot counter m, where the initial values are set as follows: P=0; N=0; and m=1. The averaged code tracking error signal *P(m)* is then determined 215 using the expression above, and more particularly the sign of the averaged code tracking error signal *P(m)* is determined i.e. positive or negative. This is done by determining 220 whether the averaged code tracking error signal *P(m)* is greater or less than 0. When the averaged code tracking error signal *P(m)* is greater than 0, the positive counter P is incremented 225 by one, and when the averaged code tracking error signal *P(m)* is less than 0, the negative counter N is incremented 230 by one.

Subsequently, a determination 235 is made as to whether the slot counter m is greater than 16. When the slot counter m is less than 16, then the operation 200 returns to step 215 of determining the averaged code tracking error signal *P(m)* and proceeds as described above. However, when the slot counter m is greater than 16, a further determination 245 is made as to whether the positive counter P is greater than ten. When the positive counter P is greater than ten, a timing control output of 1 is provided 250 by the loop filter 138, and the operation 200 then returns to the initialization step 210. However, when the positive counter P is less than ten, yet another determination 255 is made as to whether the negative counter N is greater than ten. When the negative counter N is greater than ten, a timing control output of -1 is provided 260 by the loop filter 138, and the operation 200 returns to the initialization step 210. Alternatively, when the negative counter N is less than ten, a timing control output of 0 is provided 265 by the loop filter 138, and the operation 200 returns to the initialization step 210.

When the timing module 139 receives the timing control output 1 from the loop filter 138, the timing module 139 delays the timing of the down sampler 131; when the timing module 139 receives the timing control output -1 from the loop filter 138, the timing module 139 advances the timing of the down sampler 131; and when the timing module 139 receives the timing control output 0 from the loop filter 138, the timing module 139 does not change the timing of the down sampler 131.

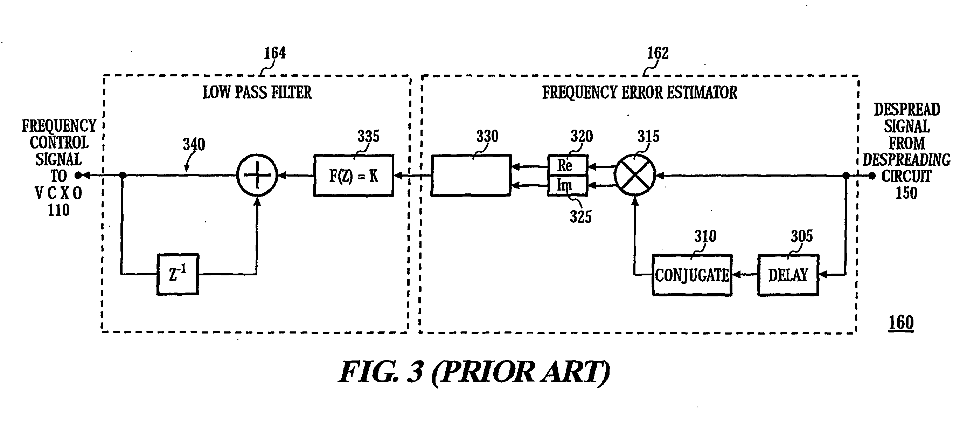

With reference to FIG. 3, a description of the control signal generating circuit 160 now follows. The frequency error estimator 162 receives the despread signal from the despreading circuit 150, where the despread signal is at the symbol rate with a symbol period T. A delayed conjugate of the despread signal is produced by a delay module 305 and a conjugate module 310, and a multiplier 315 then multiplies the delayed conjugate version of the despread signal with the despread signal to produce a resultant signal $Z_m$, which can be written as follows:

$$Z_m = d_m d^{*}_{m-1} \exp(j2\pi\Delta fT)$$

where, $d_m$ is the data bit of the current symbol m;
where $d_{m-1}$ is the data bit of last symbol m-1; and
where $\Delta f$ is the frequency error i.e. $\Delta f$ =f1-f1'.

Since the CPICH channel is the pilot channel, then $d_m = d_{m-1} = 0.707 + 0.707j$, therefore the frequency error $\Delta f$ can be determined by the following equation:

$$\Delta fT = \frac{1}{2\pi}\tan^{-1}\left[\frac{\sum_{m=1}^{L} I_m(Z_m)}{\sum_{m=1}^{L} R_e(Z_m)}\right]$$

where, $R_e$ and $I_m$ are the real and imaginary parts of $Z_m$, respectively; and
where L is the number of accumulation.

The equation above for determining the frequency error $\Delta f$ is implemented by the combination of a real accumulator 320, an imaginary accumulator 325, and an inverse tangent processor 330.

Upon obtaining the frequency error $\Delta f$, it is provided to the low pass filter 164, which consist of a multiplier 335 and an integrator 340. After filtering and integration, a resultant frequency control signal is provided to the VCXO 110 to control the frequency of the VCXO 110, to make the frequency error $\Delta f$ tend to zero.

A disadvantage of the control signal generating circuit 160 is its complexity in implementation. For example, the frequency error estimator 162 itself comprises a variety of components including the delay module 305, the conjugate module 310, the multiplier 315, the real accumulator 320 and the imaginary accumulator 325. In addition, the DSP software to provide the inverse tangent processor 330 adds to the complexity of the control signal generating circuit 160.

In implementation, the inverse tangent function can be realized by a series expansion, as follows:

$$\tan^{-1}(x) = x - \frac{x^3}{3} + \frac{x^5}{5} - \frac{x^7}{7} + \ldots + \frac{(-1)^n x^{2n+1}}{(2n+1)} \quad |x| < 1$$

or as follows:

$$\tan^{-1}(x) \approx x \qquad x \to 0$$

However, the above formula has some approximation errors, which is yet another disadvantage of the control signal generating circuit 160.

US patent no. 6289061 by Kandala teaches a control signal generating circuit that receives a despread signal from a combiner of outputs from several rake fingers, and the control signal generating circuit determines a frequency error from the despread signal. The need for a combiner and the need to process the despread signal to produce a frequency control signal makes Kandala's control signal generating circuit relatively as complex as the control signal generating circuit 160.

Hence, there is a need for a control signal generating circuit that is relatively less complex to realize and is less prone to approximation errors.

Brief Summary of the Invention

The present invention seeks to provide a method and apparatus for a control signal generating circuit, which overcomes or at least reduces the abovementioned problems of the prior art.

Accordingly, in one aspect, the present invention provides a control signal generating circuit for an automatic frequency control (AFC) circuit, the control signal generating circuit comprising:

an input for coupling to a tracking circuit of the AFC circuit to receive a digital timing control signal therefrom;
a processor for receiving the digital timing control signal and producing a frequency control signal; and
an output for coupling to a variable frequency generator of the AFC circuit to provide the frequency control signal thereto, the frequency control signal for determining output frequency of the variable frequency generator.

In another aspect the present invention provides a method for generating a frequency control signal for an automatic frequency control (AFC) circuit, the method comprising:

a) receiving a digital timing control signal from a tracking circuit of the AFC circuit;
b) processing the digital timing control signal to produce the frequency control signal; and
c) providing the frequency control signal to a variable frequency generator of the AFC circuit, wherein the frequency control signal determines output frequency of the variable frequency generator.

In yet another aspect the present invention provides a control signal generating circuit for an automatic frequency control (AFC) circuit, the control signal generating circuit comprising:

an input for coupling to a tracking circuit of the AFC circuit to receive a digital timing control signal therefrom;
a controller for receiving the digital timing control signal, and the controller for passing at least a portion of the digital timing control signal;
a processor for receiving the at least the portion of the digital timing control signal and producing a frequency control signal; and
an output for coupling to a variable frequency generator of the AFC circuit to provide the frequency control signal thereto, the frequency control signal for determining output frequency of the variable frequency generator.

In still another aspect the present invention provides a method for generating a frequency control signal for an automatic frequency control (AFC) circuit, the method comprising:

a) receiving a digital timing control signal from a tracking circuit of the AFC circuit;
b) passing at least a portion of the digital timing control signal;
c) processing the at least the portion of the digital timing control signal to produce the frequency control signal; and
d) providing the frequency control signal to a variable frequency generator of the AFC circuit, wherein the frequency control signal determines output frequency of the variable frequency generator.

Brief Description of the Drawings

An embodiment of the present invention will now be more fully described, by way of example, with reference to the drawings of which:

FIG. 1 shows a functional block diagram of a prior art CDMA receiver comprising an AFC circuit;
FIG. 2 shows a flowchart detailing the operation of a loop filter in the tracking circuit of the AFC circuit in FIG. 1;
FIG. 3 shows a functional block diagram of a control signal generating circuit in the AFC circuit in FIG. 1;
FIG. 4 shows a CDMA receiver with an AFC circuit that employs a first embodiment of a control signal generating circuit in accordance with the present invention;
FIG. 5 shows a functional block diagram of the first embodiment of the control signal generating circuit in the AFC circuit in FIG. 4;
FIG. 6 shows a flowchart detailing the operation of the first embodiment of the control signal generating circuit in FIG. 5;
FIG. 7 shows a CDMA receiver with an AFC circuit that employs a second embodiment of a control signal generating circuit in accordance with the present invention;
FIG. 8 shows a functional block diagram of a control signal generating circuit in the AFC circuit in FIG. 7; and
FIG. 9 shows a flowchart detailing the operation of the control signal generating circuit in FIG. 8.

Detail Description of the Drawings

A control signal generating circuit in accordance with the present invention receives a timing control signal from the output of the digital loop filter of a tracking circuit, and produces a frequency control signal that is provided to a VCXO. The control signal generating circuit comprises a multiplier and an integrator which are relatively simple to implement, and does not require complex processes, such as inverse tangent processing of the prior art. Consequently, approximation errors related to complex processes, such the inverse tangent processor of the prior art, are avoided.

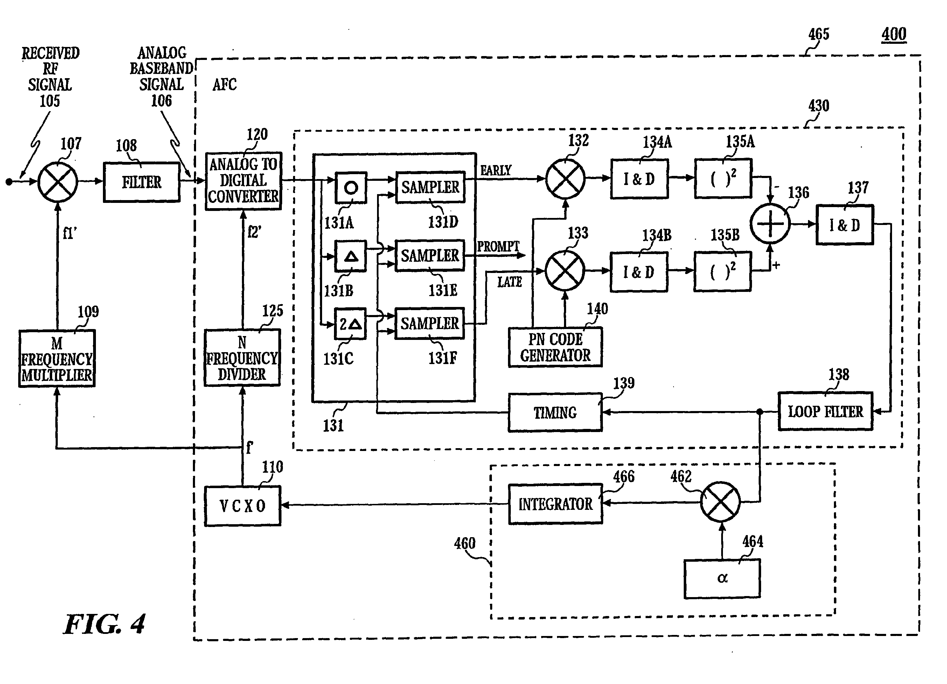

With reference to FIG. 4, a CDMA receiver 400 comprises similar components as that shown in the CDMA receiver 100 in FIG.1, except for the absence of the spreading circuit 150 and the control signal generating circuit 160, and the presence of a first embodiment of a control signal generating circuit 460, in accordance with the present invention. The receiver 400 comprises an AFC circuit 465, which itself comprises a tracking circuit 430, and the control signal generating circuit 460. The control signal generating circuit 460 is coupled to receive a timing control signal, comprising discrete timing control outputs, from the output of the digital loop filter 138 of the tracking circuit 430, and produces a frequency control signal that is provided to the VCXO 110.

Hence, the control signal generating circuit in accordance with the present invention, advantageously uses the existing timing control outputs of the loop filter in a tracking circuit to produce the frequency control signal, which in turn determines the frequency of the VCXO. This avoids the need for additional despreading and combining circuitry, as taught by the prior art.

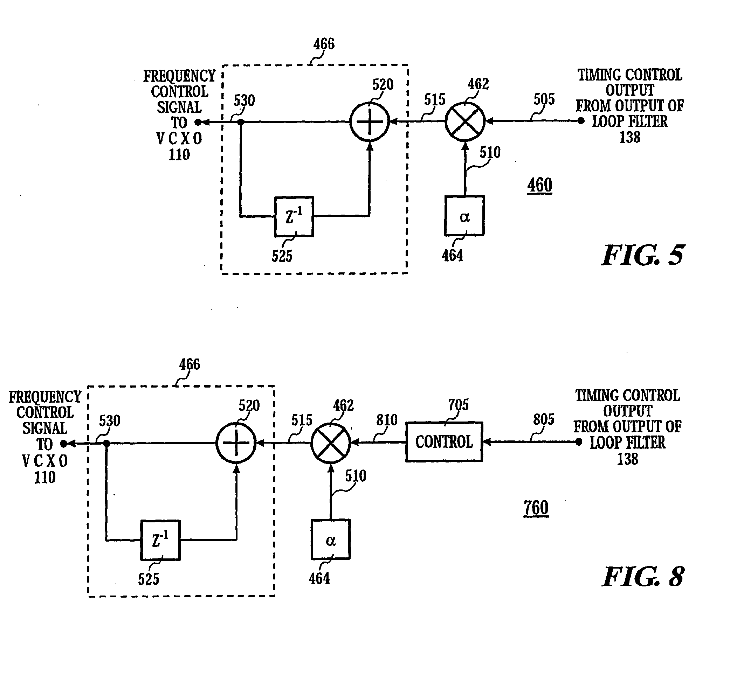

With reference to FIG. 5 the control signal-generating circuit 460 performs the role of a processor, and comprises a multiplier 462 and an integrator 466. The multiplier 462 has an input 505 that is coupled to receive the timing control outputs from the loop filter 138; and another input 510, which is coupled to receive a multiplier $\alpha$. The multiplier 460 provides a resultant signal at its output 515 comprising the product of the timing control output and $\alpha$. The multiplier 460 in effect amplifies the timing control output by an amplification factor represented by $\alpha$, to produce a resultant amplified timing control output.

The integrator 460 comprises an adder 520 and a delay module 525, and has an input that is coupled to the output 515 to receive the resultant signal, integrate it, and provide the frequency control signal at its output 530.

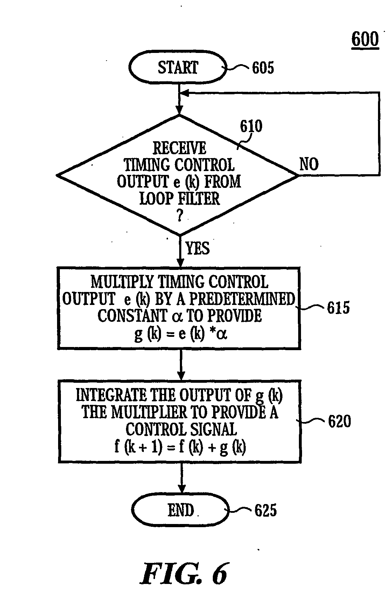

With reference to FIG. 6, the operation 600 of the control signal generating circuit 460 starts 605 with determining 610 whether a timing control output e(k) has been received 610 from the output of the loop filter 138. The timing control output, as mentioned above can have one of three states i.e. 1, 0 or -1. When none are received 610, the control signal generating circuit continues to monitor the output of the loop filter 138 for timing control outputs.

When a timing control output is received 610, the multiplier 462 multiplies 615 the received timing control output e(k) by the multiplier $\alpha$, producing the resultant signal

$$g(k) = e(k) * \alpha.$$

The integrator 466 receives the resultant signal g(k) and integrates it to produce the frequency control signal

$$f(k+ 1) = f(k) + g(k)$$

The operation 600 of the control signal generator 460 then ends 625, and is repeated when each timing control output is received from the loop filter 138.

As will be known to one skilled in the art in relation to a PLL, the acquisition bandwidth $B_{acq}$ of the AFC is

$$B_{acq} = \sqrt{\frac{K}{\tau_1}}$$

where $K=K_{vc0}*\alpha$.

Where $K_{vco}$ is the voltage control sensitivity of the VXCO 110, the value of $K_{vco}$ is determined by the particular component of VCXO adopted. It has the unit of Hz/Voltage. $\alpha$ is the design parameter, it has the unit of Voltage.

Where, $\tau_1$ is the time constant, and is determined by L in control signal generating circuit 160 of the prior art, or is determined by error signal average time in tracking circuit 430 according to present invention.

$\alpha$ is a design parameter, which determines the AFC circuit 465 acquisition bandwidth. $\alpha$ is chosen to be a relatively small value, as selection of a large value for $\alpha$ can prevent the AFC circuit 465, which is a PLL, from locking. In addition, the value of $\alpha$ effects the lock-in time of the AFC circuit 465, as well as the steady state error of the AFC 465. When the value of $\alpha$ is increased, the AFC circuit 465 will take a shorter time to lock, however the steady state error will tend to degrade. Alternatively, when the value of $\alpha$ is decreased, the AFC circuit 465 will take a longer time to lock, however it will have a relatively better steady error. Therefore, the value of $\alpha$ will need to be carefully chosen to balance the performance of the lock in time and steady state error of the AFC 465. The determination of $\alpha$ through calculation will be known to one skilled in the art, and such information can be found in publications dealing with AFC circuits and PLLs.

In order to illustrate the performance of the AFC circuit 465 using the control signal generating circuit 460, relative to the AFC circuit 165 using the prior art control signal generating circuit 160, simulation was conducted, and the results are presented hereinbelow. The simulation was performed on COSSAP, a system level simulation tool by Synopsis. The following parameters were applied in the simulation:

1. The Eb/N0 =6 dB for an AWGN channel.
2. The Eb/N0 =10 dB for a Rayleigh fading channel, the parameter of the fading channel is shown is TABLE 1 below.

TABLE 1

| Speed 50km/ h | |
|---|---|
| Relative Delay (ns) | Relative Power (dB) |
| 0 | 0 |
| 976 | -10 |

3. The frequency error is 3ppm, for a 2GHz carrier, corresponding to a 6KHz frequency offset.

4. For the prior art control signal generating circuit 160, $K_{vco}*\alpha$ =0.1 ppm and 0.2 ppm; L=50 (L is a parameter that is used to estimate the frequency error, and L=50 means that the frequency error estimation is updated every 1/3 frame (1 frame =10ms), and in this case, $\tau_1$ =3.3ms); and the PN code tracking is updated every frame.

5. For the control signal generating circuit in accordance with the present invention, as described, $K_{vco}*\alpha$=0.2 ppm, 0.3 ppm; and the PN code tracking is updated every 3 frames, in this case, $\tau_1$=300 ms.

In addition, to assess the effect of the initial PN code phase error the following parameters are applied in the simulation:

6. The relative frequency error, between a reference frequency at the transmitter and a reference frequency at a receiver, is set to 0 parts per million (ppm);

7. The initial PN code phase error is _ chip and _ chip, and this assumption is reasonable: after path search, where the initial phase error is normally within _ chip;

8. The channel is a Rayleigh fading channel as shown in TABLE 1, above;

9. The Eb/NO =10 dB; and

10. $K_{vco}*\alpha$ = 0.2 ppm.

TABLE 2 below shows a comparison the performance on a additive white Gaussian noise (AWGN) communication channel.

TABLE 2

| | $(1/\tau_1)*K_{vco}*\alpha$ | Lock Time | Possible maximum steady state error | Steady state error | BER for DPCH |
|---|---|---|---|---|---|
| Prior Art | 300*0.1ppm | 120 ms | - | 0.05ppm | 0.00387 |
| | 300*0.2ppm | 80ms | - | 0.006ppm | 0.0030 |
| Present Invention | 3*0.2ppm | 1000 ms | 0.2ppm | 2.5e-7ppm | 0.00286 |
| | 3*0.3ppm | 700ms | 0.3ppm | 0 | 0.00285 |

TABLE 3 below shows a comparison the performance on a Rayleigh fading communication channel.

TABLE 3

| | $(1/\tau_1)*K_{vco}*\alpha$ | Lock Time | Possible maximum steady state error | Steady state error | BER for DPCH |
|---|---|---|---|---|---|
| Prior Art | 300*0.1 ppm | 130ms | - | 0.06ppm | 0.03205 |
| | 300*0.2ppm | 85ms | - | 0.02ppm | 0.03144 |
| Present Invention | 3*0.2ppm | 1000ms | 0.2ppm | 2.5e-7ppm | 0.03065 |
| | 3*0.3ppm | 700ms | 0.3ppm | 0 | 0.03062 |

From TABLES 2 and 3, the AFC circuit 465 that uses the signal generating circuit 460 of the present invention, advantageously provides an improved steady state error performance relative to the prior art. However, since present invention as described provides a control signal generating circuit that couples directly to the output of a low pass filter of a tracking circuit, and produces a frequency control signal for coupling to a VCXO, in the case of initial PN code phase error, the frequency response of the AFC may be disturbed by the initial PN code phase error.

A second embodiment of the control signal generating circuit 760 will now be described, which results in improved frequency response performance.

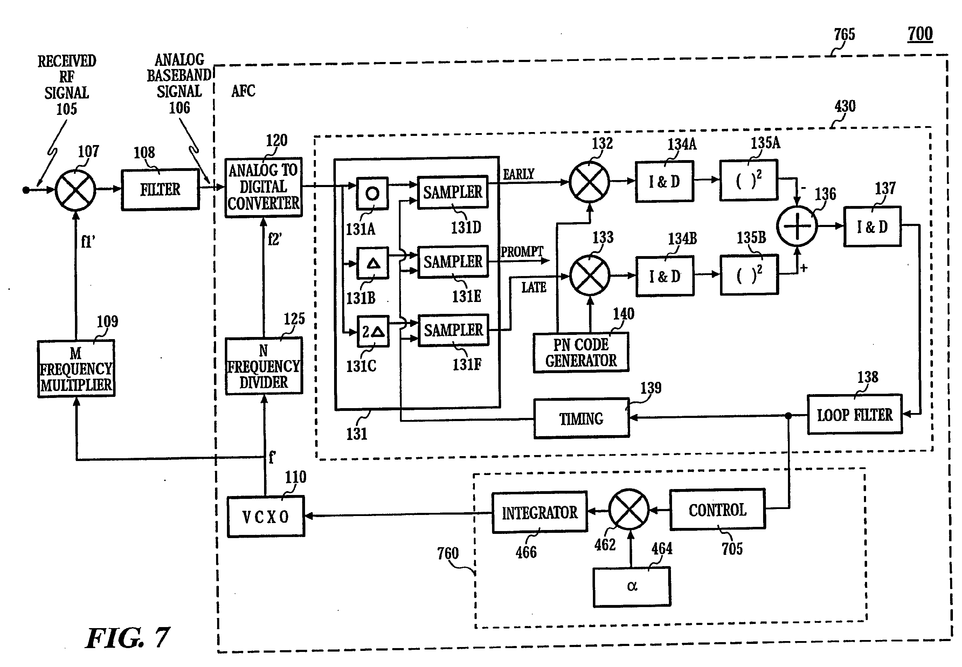

With reference now to FIG. 7, a CDMA receiver 700 comprises similar components as that shown in the CDMA receiver 400 in FIG.4, with the exception of a second embodiment of a control signal generating circuit 760, in accordance with the present invention. The control circuit 760 discards a predetermined number m, of the first timing control outputs from the low pass filter 138. In this description, the first 5 timing control outputs are discarded. A description of the cause of the disturb time now follows.

When there is no frequency error i.e. where the frequency error equals to 0ppm, there is an initial PN code phase error. When the first several outputs from the PN tracking loop is not discarded, the initial PN code phase error causes a disturb time in the AFC circuit 765, which can last for about 750 ms. During this disturb time, the maximum frequency error is 0.6 ppm for _ chip initial error and 0.4 ppm for _ chip initial error. For the _ chip initial error case, within 180ms the frequency error will come back to 0.2 ppm and for another 400 ms, it will converge to 0. For the _ chip initial error case, within 360ms the frequency error will come back to 0.2 ppm and for another 300 ms, it will converge to 0. It will be appreciated by one skilled in the art, that in a typical AFC circuit, the initial PN code phase error will also effect the AFC loop. Due to the local PN code being out of synchronization with the PN code of the input signal, the correlation output of the CPICH channel is effected, which further effect the frequency error estimation.

Returning now to FIG. 7, the receiver 700 comprises an AFC circuit 765, which itself comprises the tracking circuit 430, and the control signal generating circuit 760. As with the first embodiment, the control signal generating circuit 760 is coupled to receive a timing control signal, comprising discrete timing control output, from the output of the digital loop filter 138 of the tracking circuit 430, and produces a frequency control signal that is provided to the VCXO 110.

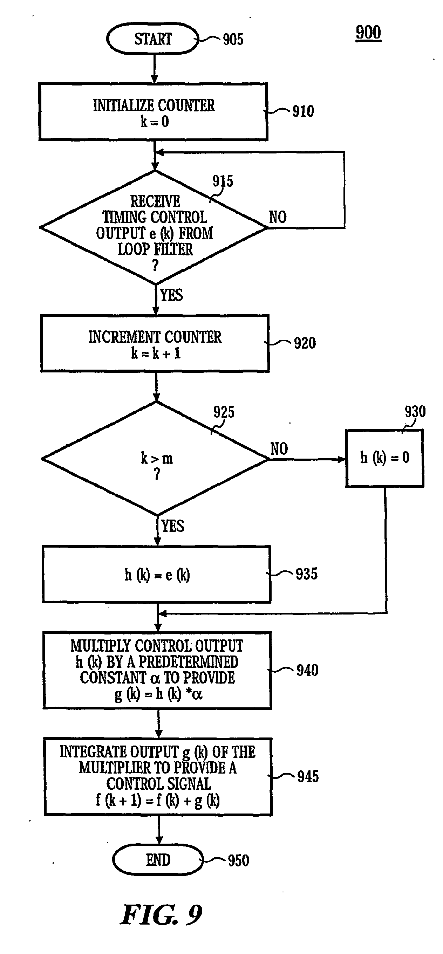

With reference to FIG. 8 the control signal generating circuit 760 includes all the elements of the control signal generating circuit 460, and also includes a control module 705. The control module 705 has an input 805 that is coupled to receive the timing control output from the loop filter 138, and an output 810 that is coupled to provide either the timing control output as received from the loop filter 138, or to provide a frequency unchanged output i.e. where the output is zero.

The multiplier 462 has an input that is coupled to the output 810; and another input 510, which is coupled to receive a multiplier $\alpha$. The multiplier 462 provides a resultant signal at its output 515 comprising the product of the timing control output, received from the output 810, and $\alpha$. The integrator 466 comprises an adder 520 and a delay module 525, and has an input that is coupled to the output 515 to receive the resultant signal, integrate it, and provide the frequency control signal at its output 530.

With reference to FIG. 9, the operation 900 of the control signal generating circuit 760 starts 905 with initializing 910 a timing control output counter k to 0 i.e. k = 0. It is then determined 915 whether a timing control output e(k) has been received from the output of the loop filter 138. When none is received the operation 900 continues to monitor the output of the loop filter, however, when a timing control output e(k) is received, the counter k is incremented 920 by 1 i.e. k=k+1. Subsequently, another determination 925 is made as to whether the current counter value k is greater than a predetermine number m, and when it is not, the control module 705 provide a frequency unchanged output. Hence, the output 930 of the control module is h(k) = 0.

When the current counter value k is greater than a predetermine number m, the control module provides the received timing control output e(k). Hence, the output 935 of the control module is h(k) = e(k). The multiplier 462 then multiplies 940 the received timing control output h(k) by the multiplier $\alpha$, producing the resultant signal

$$g(k) = h(k) * \alpha$$

The integrator 466 receives the resultant signal g(k) and integrates it to produce the frequency control signal

$$f(k+1) = f(k) + g(k)$$

The operation 900 of the control signal generator 760 then ends 950.

In effect, the control module advantageously prevents a predetermined number of timing control outputs m from being processed by the multiplier 462 and the integrator 466, which improves the frequency response of the AFC circuit 765 in case of initial PN code phase error. In a receiver, when the path is initially assigned by the Rake management, the first few outputs from the PN code generator is not used to adjust the AFC 765, and the input to the AFC circuit 765 is 0. This results in no change in frequency.

The performance of the AFC circuit 765 is illustrated by the simulation results in TABLE 4 where none of the timing control outputs are discarded, in comparison with TABLE 5 where the first five timing control outputs are discarded.

TABLE 4

| | Initial PN code phase error | Disturb time | Maximum frequency error | Steady state error | BER for DPCH |
|---|---|---|---|---|---|
| Present Invention $(1/\tau_1)^*$ $K_{vco}$ $^*\alpha$ =3*0.2ppm | _chip | 750ms | 0.4ppm | 2.8e-8ppm | 0.03063 |
| | _chip | 750ms | 0.6ppm | 2.8e-8ppm | 0.03063 |

TABLE 5

| | Initial PN code phase error | Disturb time | Maximum frequency error | Steady state error | BER for DPCH |
|---|---|---|---|---|---|
| Present Invention $(1/\tau 1)$ $^* K_{vco}$ $^*\alpha$ =3*0.2ppm | _chip | 0ms | 0 | 0 | 0.03058 |
| | _chip | 0ms | 0 | 0 | 0.03058 |

From TABLES 4 and 5, it will be appreciated that the frequency response performance of the AFC circuit 765 that uses the second embodiment of the control signal generating circuit 760 provides improved frequency response performance.

The present invention as described provides a control signal generating circuit that couples directly to the output of a low pass filter of a tracking circuit, and produces a frequency control signal for coupling to a VCXO.

This is accomplished by multiplying each timing control output received from the output of the low pass filter to produce a resultant signal. The resultant signal is then integrated to produce the frequency control signal. For improved frequency response performance, a controller is used to discard the first few timing control outputs from the low pass filter. As the control signal generating circuit of the present invention comprises a multiplier and an integrator, it is relatively simple in construction and easier to implement. In addition, as the implementation is not dependent on a formula, which suffers approximation errors, the control signal generating circuit of the present invention is not adversely affected by approximation errors.

Thus, the present invention, as described provides a method and apparatus for a control signal generating circuit, which overcomes or at least reduces the abovementioned problems of the prior art.

It will be appreciated that although only particular embodiments of the invention have been described in detail, various modifications and improvements can be made by a person skilled in the art without departing from the scope of the present invention.

**Claims**

1. A control signal generating circuit for an automatic frequency control (AFC) circuit, the control signal generating circuit comprising:

an input for coupling to a tracking circuit of the AFC circuit to receive a digital timing control signal therefrom;
a processor for receiving the digital timing control signal and producing a frequency control signal; and
an output for coupling to a variable frequency generator of the AFC circuit to provide the frequency control signal thereto, the frequency control signal for determining output frequency of the variable frequency generator.

2. A control signal generating circuit in accordance with claim 1, wherein the processor comprises an amplifier coupled to receive the digital timing control signal and a predetermined amplification factor, the amplifier for amplifying the digital timing control signal by the predetermined amplification factor to produce an amplified digital timing control signal, and the amplifier having an output coupled to provide the amplified digital timing control signal.

3. A control signal generating circuit in accordance with claim 2 wherein the processor further comprises an integrator having an input coupled to receive the amplified digital timing control signal, the integrator for integrating the amplified digital timing control signal to produce the frequency control signal, and the integrator having an output coupled to provide the frequency control signal.

**4.** A control signal generating circuit in accordance with claim 2, wherein the amplifier comprises a multiplier, and wherein the predetermined amplification factor comprises a predetermined multiplication factor, the multiplier for multiplying the digital timing control signal by the predetermined multiplication factor to produce a multiplied digital timing control signal, and wherein the amplified timing control signal comprises the multiplied digital timing control signal.

**5.** A control signal generating circuit in accordance with claim 3 wherein the input for coupling to the tracking circuit of the AFC circuit is adapted to receive a plurality of digital outputs.

**6.** A control signal generating circuit in accordance with claim 3 wherein the input for coupling to the tracking circuit of the AFC circuit is adapted to receive at least three digital outputs, wherein the at least three digital outputs represent three different logic states.

**7.** A control signal generating circuit in accordance with claim 3 wherein the input for coupling to the tracking circuit of the AFC circuit is adapted to receive three digital outputs, wherein a first of the three digital outputs indicates timing delay, wherein a second of the three digital outputs indicates timing advance, and wherein a third of the three digital outputs indicates timing remains unchanged.

**8.** A method for generating a frequency control signal for an automatic frequency control (AFC) circuit, the method comprising:

a) receiving a digital timing control signal from a tracking circuit of the AFC circuit;
b) processing the digital timing control signal to produce the frequency control signal; and
c) providing the frequency control signal to a variable frequency generator of the AFC circuit, wherein the frequency control signal determines output frequency of the variable frequency generator.

**9.** A method in accordance with claim 8, wherein (a) comprises receiving a plurality of digital outputs.

**10.** A method in accordance with claim 8, wherein (a) comprises receiving at least three digital outputs, wherein the at least three digital outputs represent three different logic states.

**11.** A method in accordance with claim 8, wherein (a) comprises receiving three digital outputs, wherein a first of the three digital outputs indicates timing delay, wherein a second of the three digital outputs indicates timing delay, and wherein a third of the three digital outputs indicates timing remains unchanged.

**12.** A method in accordance with claim 8, wherein (b) comprises amplifying the digital timing control signal by a predetermined amplification factor to produce an amplified digital timing control signal, and providing the amplified digital timing control signal.

**13.** A method in accordance with claim 12, wherein (b) comprises multiplying the digital timing control signal by a predetermined multiplication factor to produce a multiplied digital timing control signal, and providing the multiplied digital timing control signal as the amplified digital timing control signal.

**14.** A method in accordance with claim 12, wherein (b) further comprises integrating the amplified digital timing control signal to produce the frequency control signal, and providing the frequency control signal.

**15.** A control signal generating circuit for an automatic frequency control (AFC) circuit, the control signal generating circuit comprising:

an input for coupling to a tracking circuit of the AFC circuit to receive a digital timing control signal therefrom;
a controller for receiving the digital timing control signal, and the controller for passing at least a portion of the digital timing control signal;
a processor for receiving the at least the portion of the digital timing control signal and producing a frequency control signal; and
an output for coupling to a variable frequency generator of the AFC circuit to provide the frequency control signal thereto, the frequency control signal for determining output frequency of the variable frequency generator.

**16.** A control signal generating circuit in accordance with claim 15, wherein the controller comprises an input for receiving the digital timing control signal, a determinator for determining whether a predetermined initial portion of the digital timing control signal has been received, and an output for providing the at least the portion of the digital timing control signal after the initial portion of the digital timing control signal has been received.

**17.** A control signal generating circuit in accordance with claim 16, wherein the processor comprises an amplifier coupled to receive the at least the portion of the digital timing control signal and a predetermined amplification factor, the amplifier for amplifying the at least the portion of the digital timing control signal by the predetermined amplification factor to produce an amplified digital timing control signal, and the amplifier having an output coupled to provide the amplified digital timing control signal.

**18.** A control signal generating circuit in accordance with claim 17 wherein the processor further comprises an integrator having an input coupled to receive the amplified digital timing control signal, the integrator for integrating the amplified digital timing control signal to produce the frequency control signal, and the integrator having an output coupled to provide the frequency control signal.

**19.** A control signal generating circuit in accordance with claim 17, wherein the amplifier comprises a multiplier, and wherein the predetermined amplification factor comprises a predetermined multiplication factor, the multiplier for multiplying the at least the portion of the digital timing control signal by the predetermined multiplication factor to produce a multiplied digital timing control signal, and wherein the amplified timing control signal comprises the multiplied digital timing control signal.

**20.** A control signal generating circuit in accordance with claim 18 wherein the input for coupling to the tracking circuit of the AFC circuit is adapted to receive a plurality of digital outputs, wherein the predetermined initial portion of the digital timing control signal comprises a predetermined number of the plurality of digital outputs, and wherein the determinator comprises a counter for counting the predetermined number of digital outputs.

**21.** A control signal generating circuit in accordance with claim 18 wherein the input for coupling to the tracking circuit of the AFC circuit is adapted to receive at least three digital outputs, wherein the at least three digital outputs represent three different logic states.

**22.** A control signal generating circuit in accordance with claim 18 wherein the input for coupling to the tracking circuit of the AFC circuit is adapted to receive three digital outputs, wherein a first of the three digital outputs indicates timing delay, wherein a second of the three digital outputs indicates timing delay, and wherein a third of the three digital outputs indicates timing remains unchanged.

**23.** A method for generating a frequency control signal for an automatic frequency control (AFC) circuit, the method comprising:

a) receiving a digital timing control signal from a tracking circuit of the AFC circuit;
b) passing at least a portion of the digital timing control signal;
c) processing the at least the portion of the digital timing control signal to produce the frequency control signal; and
d) providing the frequency control signal to a variable frequency generator of the AFC circuit, wherein the frequency control signal determines output frequency of the variable frequency generator.

**24.** A method in accordance with claim 23, wherein (b) comprises determining whether a predetermined initial portion of the digital timing control signal has been received, and providing the at least the portion of the digital timing control signal after the predetermined initial portion of the digital timing control signal has been received.

**25.** A method in accordance with claim 24, wherein (a) comprises receiving a plurality of digital outputs.

**26.** A method in accordance with claim 25, wherein the predetermined initial portion of the digital timing control signal comprises a predetermined number of the plurality of digital outputs, and wherein determining the whether the predetermined initial portion of the digital timing control signal has been received comprises counting the predetermined number of the plurality of digital outputs.

**27.** A method in accordance with claim 23, wherein (a) comprises receiving at least three digital outputs, wherein the at least three digital outputs represent three different logic states.

**28.** A method in accordance with claim 23, wherein (a) comprises receiving three digital outputs, wherein a first of the three digital outputs indicates timing delay, wherein a second of the three digital outputs indicates timing delay, and wherein a third of the three digital outputs indicates timing remains unchanged.

**28.** A method in accordance with claim 23, wherein (c) comprises amplifying the at least the portion of the digital timing control signal by a predetermined amplification factor to produce an amplified digital timing control signal, and providing the amplified digital timing control signal.

**29.** A method in accordance with claim 28, wherein amplifying the at least the portion of the digital timing control signal by a predetermined amplification factor comprises multiplying the at least the portion digital timing control signal by a predetermined multiplication factor to produce a multiplied digital timing control signal, and providing the multiplied digital timing control signal as the amplified digital timing control signal.

**30.** A method in accordance with claim 28, wherein (c) further comprises integrating the amplified digital timing control signal to produce the frequency control signal, and providing the frequency control signal.

*FIG. 1 (PRIOR ART)*

START ~205

200

INITIALIZATION
P=0; N=0; m=1 ~210

$b(m) = SIGN[\hat{P}(m)]$ ~215

220
$b(m) > 0$
?

NO

YES

225
$P = P+1$

230
$N = N+1$

235
$m > 16$
?

NO

240
$m = m+1$

YES

245
$P > 10$
?

NO

255
$N > 10$
?

NO

YES

YES

250
OUTPUT = 1
TIMING DELAY

260
OUTPUT = -1
TIMING ADVANCE

265
OUTPUT = 0
TIMING UNCHANGED

*FIG. 2 (PRIOR ART)*

**FIG. 3 (PRIOR ART)**

**FIG. 4**

EP 1 416 638 A1

466

FREQUENCY
CONTROL
SIGNAL        530                          520        515      462        505    TIMING CONTROL
TO ●                                          ⊕ ←      ⊗ ←          ●      OUTPUT
V C X O                                                                         FROM OUTPUT OF
110                                                                             LOOP FILTER
                                                         510                    138

                                                                        460

                      $Z^{-1}$                            α

                      525                               464

**FIG. 5**

466

FREQUENCY
CONTROL
SIGNAL        530                          520        515    462    810          705          805    TIMING CONTROL
TO ●                                          ⊕ ←      ⊗ ←          CONTROL ←          ●      OUTPUT
V C X O                                                                                             FROM OUTPUT OF
110                                                                                                 LOOP FILTER
                                                         510                                        138

                                                                                        760

                      $Z^{-1}$                            α

                      525                               464

**FIG. 8**

<u>600</u>

START ~605

RECEIVE TIMING CONTROL OUTPUT e (k) FROM LOOP FILTER ? — 610 — NO

YES

MULTIPLY TIMING CONTROL OUTPUT e (k) BY A PREDETERMINED CONSTANT $\alpha$ TO PROVIDE $g (k) = e (k) * \alpha$ ~615

INTEGRATE THE OUTPUT OF g (k) THE MULTIPLIER TO PROVIDE A CONTROL SIGNAL $f (k + 1) = f (k) + g (k)$ ~620

END ~625

## FIG. 6

**FIG. 7**

900

START ~905

INITIALIZE COUNTER
k = 0 ~910

915
RECEIVE
TIMING CONTROL
OUTPUT e (k) FROM
LOOP FILTER
? → NO

YES

INCREMENT COUNTER
k = k + 1 ~920

925
k > m
? → NO → h (k) = 0  930

YES

h (k) = e (k) ~935

MULTIPLY CONTROL OUTPUT
h (k) BY A PREDETERMINED
CONSTANT α TO PROVIDE
g (k) = h (k) *α ~940

INTEGRATE OUTPUT g (k) OF THE
MULTIPLIER TO PROVIDE A
CONTROL SIGNAL
f (k + 1) = f (k) + g (k) ~945

END ~950

**FIG. 9**

**European Patent Office**

**EUROPEAN SEARCH REPORT**

Application Number

EP 03 25 6836

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 579 338 A (KOJIMA TOSHIHARU) 26 November 1996 (1996-11-26) | 1-19, 21-25, 27-31 | H03L7/093 H04B1/707 |
| Y | * column 6, line 15 - column 8, line 2; figures 5,6 * | 20,26 | |
| X | WO 00 67387 A (KONINKL PHILIPS ELECTRONICS NV) 9 November 2000 (2000-11-09) * page 2, line 10 - page 5, line 13; figures 1-3,7 * | 1-31 | |
| X | WO 01 76089 A (QUALCOMM INC) 11 October 2001 (2001-10-11) | 1,8,15, 23 | |
| Y | * page 9, line 3 - page 11, line 23; figures 2-5 * | 20,26 | |
| X | US 5 590 160 A (OSTMAN KJELL) 31 December 1996 (1996-12-31) | 1,8,15, 23 | |
| Y | * column 6, line 32 - column 9, line 50; figures 8,12 * | 20,26 | |

TECHNICAL FIELDS SEARCHED (Int.Cl.7)

H03L
H04B

The present search report has been drawn up for all claims

| Place of search | Date of completion of the search | Examiner |
|---|---|---|
| MUNICH | 6 February 2004 | Waters, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 03 25 6836

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2004

| Patent document cited in search report | | Publication date | Patent family member(s) | | Publication date |
|---|---|---|---|---|---|
| US 5579338 | A | 26-11-1996 | JP | 2672769 B2 | 05-11-1997 |
| | | | JP | 6077932 A | 18-03-1994 |
| WO 0067387 | A | 09-11-2000 | CN | 1302483 T | 04-07-2001 |
| | | | WO | 0067387 A1 | 09-11-2000 |
| | | | EP | 1095466 A1 | 02-05-2001 |
| | | | JP | 2002543734 T | 17-12-2002 |
| | | | TW | 503630 B | 21-09-2002 |
| WO 0176089 | A | 11-10-2001 | US | 6628675 B1 | 30-09-2003 |
| | | | AU | 5388001 A | 15-10-2001 |
| | | | CA | 2404303 A1 | 11-10-2001 |
| | | | CN | 1432219 T | 23-07-2003 |
| | | | EP | 1269651 A2 | 02-01-2003 |
| | | | JP | 2003534681 T | 18-11-2003 |
| | | | WO | 0176089 A2 | 11-10-2001 |
| US 5590160 | A | 31-12-1996 | US | 5408504 A | 18-04-1995 |
| | | | EP | 0726658 A2 | 14-08-1996 |
| | | | JP | 8256094 A | 01-10-1996 |
| | | | EP | 0605188 A2 | 06-07-1994 |
| | | | JP | 6261031 A | 16-09-1994 |

EPO FORM P0459

For more details about this annex : see Official Journal of the European Patent Office, No. 12/82